# EUROPÄISCHE PATENTSCHRIFT

(11) **EP 3 155 328 B1**
(45) Veröffentlichungstag und Bekanntmachung des Hinweises auf die Patenterteilung: **01.12.2021**
(21) Anmeldenummer: 15723844.5
(22) Anmeldetag: 20.05.2015
(51) Int. Cl.: F25B 21/02, F25D 23/06

(54) **KÜHL- UND/ODER GEFRIERGERÄT**
REFRIGERATOR AND/OR FREEZER
APPAREIL DE FROID ET/OU DE CONGÉLATION

(30) Priorität: 16.06.2014 DE 102014008668
(43) Veröffentlichungstag der Anmeldung: 19.04.2017
(73) Patentinhaber: Liebherr-Hausgeräte Ochsenhausen GmbH, 88416 Ochsenhausen (DE); Liebherr-Hausgeräte Lienz GmbH, 9900 Lienz (AT)
(72) Erfinder: HIEMEYER, Jochen, 97753 Karlstadt (DE); FREITAG, Michael, 97082 Würzburg (DE); KERSTNER, Martin, 97072 Würzburg (DE)
(74) Vertreter: Herrmann, Uwe
(86) Internationale Anmeldenummer: PCT/EP2015/001029
(87) Internationale Veröffentlichungsnummer: WO 2015/192935

(56) Entgegenhaltungen:
- EP-A2- 0 592 044
- WO-A2-2009/003893
- CH-A2- 703 730
- US-A- 3 018 631
- US-A- 5 653 111
- US-A- 5 715 684

## Beschreibung

Die vorliegende Erfindung betrifft ein ein Kühl- und/ oder Gefriergerät mit einem gekühlten Innenraum und mit einem thermoelektrischen Element, insbesondere mit wenigstens einem Peltier-Element, zur Temperierung des Innenraums zur Kälteerzeugung in dem gekühlten Innenraum.

Aus dem Stand der Technik sind unterschiedliche Konzepte zur Kälteerzeugung bei Kühl- bzw. Gefriergeräten bekannt. In allen Fällen ist für einen größtmöglichen Wirkungsgrad und somit für eine gute Energieeffizienz ein effektiver Wärmetauscher sowohl auf der Kühlraumseite als auch auf der Abwärmeseite notwendig, um den zu überwindenden Temperaturhub so gering wie möglich zu halten. In diesem Zusammenhang ist die Ankopplung an den Bereich der Kälteerzeugung und an den Kühlraum sowie an die Außenluft von Bedeutung, an die die abgeführte Wärme abgegeben wird.

Bei üblichen Kompressionskältemaschinen werden für die Ankopplung an den Innenraum sowie an die Außenluft sowohl statische Systeme, d.h. statische Verdampfer und Verflüssiger, als auch dynamische Systeme, wie z.B. NoFrost-Verdampfer bzw. - Lüfter oder Blockverflüssiger mit Zwangskonvektion verwendet. Bei dynamischen Systemen steht der Vorteil aufgrund der erreichbaren geringen Temperaturdifferenz dem zusätzlichen Aufwand für den Massentransport für die Konvektion der Luft entgegen.

Ein wesentlicher Parameter bei der erforderlichen Kälteleistung eines Kühl- bzw. Gefriergerätes bildet die Wärmedämmung, die den gekühlten Innenraum umgibt. Verbessert man die Wärmedämmung, verringert sich der Bedarf an Kälteleistung. Bei einem geringen Kältebedarf kann die Bereitstellung durch einfachere Mittel als durch Kompressionskältemaschinen nämlich insbesondere durch thermoelektrische Elemente erfolgen. Bekannt ist beispielsweise der Einsatz von Peltier-Elementen. So benötigt beispielsweise ein kleines, durch Vakuumdämmung gedämmtefs Kühlgerät nur eine Kälteleistung von 3 - 4 W, die z.B. durch ein thermoelektrisches Element aufgebracht werden kann.

Bei dem Einsatz von Peltier-Elementen besteht eine Besonderheit darin, dass die erzeugte Kälteleistung und die Abwärme in unmittelbarer räumlicher Nähe anfallen - ein Kältemittel als Wärmeträger ist nicht vorhanden. In diesem Falle ist der Wärmeübergang zu dem gekühlten Innenraum sowie zu der Außenluft, an die die Wärme abgegeben wird, von besonderer Bedeutung. Aus dem Stand der Technik ist es bekannt, diesen Wärmeübergang bei Peltier-Kühlgeräten, wie z.B. tragbaren Kühlboxen, durch Rippenwärmetauscher und durch eine durch Ventilatoren erzeugte Luftströmung zu verbessern. Deren Leistungsbedarf liegt in einer ähnlichen Größenordnung wie der des Peltier-Elementes.

Diese Überlegungen sind aber keineswegs auf Kühl- und/oder Gefriergeräte beschränkt sondern gelten für wärmeisolierte Behältnisse im Allgemeinen.

Das wärmeisolierte Behältnis weist mindestens einen temperierten Innenraum auf, wobei dieser gekühlt oder beheizt sein kann, so dass sich in dem Innenraum eine Temperatur unterhalb oder oberhalb der Umgebungstemperatur von z.B. 21 °C ergibt.

Die US 5 715 684 A zeigt ein Kühl- und/oder Gefriergerät, das sämtliche Merkmale des Oberbegriffs des Anspruchs 1 aufweist.

Die EP 0 592 044 A2 beschreibt eine thermoelektrische Kühlvorrichtung für einen thermoelektrischen Kühlschrank, das ebenfalls die Unterschiedsmerkmale nicht offenbart.

Die US 5 653 111 A handelt von einem thermoelektrischen System mit einem thermoelektrischen Modul, von denen sowohl die kalte als auch die warme Seite mit einem Fluidwärmetauscher in Verbindung steht. Dokumente WO2009/003893, CH703730 und US3018631 offenbaren weitere ähnliche Kühl- und/oder Gefriergeräte mit eingebauten thermoelektrischen Elementen.

Der vorliegenden Erfindung liegt die Aufgabe zugrunde, ein wärmeisoliertes Behältnis, vorzugsweise Kühl- und/oder Gefriergerät der eingangs genannten Art dahingehend weiterzubilden, dass der Wärmetransport gegenüber bekannten Behältnissen, vorzugsweise Geräten verbessert ist.

Diese Aufgabe wird durch ein Kühl- und/oder Gefriergerät mit den Merkmalen des Anspruchs 1 gelöst.

Nach einem illustrativen Beispiel, das nicht ein Teil der Erfindung ist, ist vorgesehen, dass wenigstens ein Flüssigkeitswärmetauscher und/oder wenigstens eine Heatpipe vorgesehen ist, der/die derart angeordnet ist, dass dieser/diese Wärme zu dem thermoelektrischen Element, insbesondere aus dem gekühlten Innenraum zu dem thermoelektrischen Element führt und/oder Wärme von dem thermoelektrischen Element abführt.

Unter einem "Flüssigkeitswärmetauscher" ist ein Wärmetauscher zu verstehen, der mit einem flüssigen Wärmeträgermedium arbeitet. Gegenüber Luftwärmetauschern ergibt sich der Vorteil einer höheren Wärmekapazität sowie ein geringerer Strömungsverlust. Eine "Heatpipe" oder "Wärmerohr" ist ein mit einem Kältemittel gefüllter rohrförmiger Körper, an dessen warmen Ende das Kältemittel verdampft und an dessen kalten Ende das Kältemittel kondensiert, wodurch die Verdampfungsenthalpie abgegeben wird.

Dieses Beispiel, das nicht ein Teil der Erfindung ist, sieht vor, dass ein Wärmetransport, insbesondere der Transport der Abwärme aus dem gekühlten Innenraum mittels wenigstens eines Flüssigkeitswärmetauschers und/oder mittels wenigstens einer Heatpipe, d.h. mittels wenigstens eines Wärmerohres erfolgt.

Mittels des erfindungsgemäßen Wärmetransportmechanismus ist eine Verteilung der geringen Wärmeströme mit minimaler Temperaturdifferenz an die Umgebung möglich.

Der Wärmetransport aus dem gekühlten Innenraum zu der Innenwand und der Wärmetransport an der Außenhaut, sowie von der Außenhaut an die Umgebung des Gerätes findet statisch, d.h. ohne erzwungene Konvektion statt.

Der Festkörper weist vorzugsweise Metall auf oder besteht aus diesem, wobei eine bevorzugte Ausgestaltung des Metalls Aluminium bildet.

Denkbar ist es, dass Wärme von dem thermoelektrischen Element durch eine Aluminium- oder sonstige Metallstruktur auf die Gehäuseaußenfläche und/oder von der Innenfläche, die den gekühlten Innenraum begrenzt, durch eine Aluminium- oder sonstige Metallstruktur zu dem thermoelektrischen Element geleitet wird. Dabei ist die Form der Metallstruktur vorzugsweise so ausgelegt, dass der Temperaturabfall bei den anfallenden Wärmeströmen so auf die Oberfläche verteilt, dass dieser zwischen dem Ort der Wärmepumpe, d.h. dem thermoelektrischen Element, und der jeweiligen Oberfläche nur wenige Kelvin beträgt.

Vorzugsweise bildet die Metallstruktur, d.h. der genannte Festkörper teilweise oder vollständig die Außenhaut und/oder die Innenwandung des Behältnisses, vorzugsweise des Gerätes. Dabei sind alle technischen Merkmale des unabhängigen Anspruchs 1 obligatorisch für die Definition der vorliegenden Erfindung.

Vorzugsweise ist vorgesehen, dass das Kühl- und/oder Gefriergerät als Wärmedämmung des gekühlten Innenraums eine Vakuumdämmung aufweist. Eine Vakuumdämmung beispielsweise mittels Vakuumisolationspaneelen oder mittels evakuierter Gehäusewandungen und/oder mittels eines evakuierten Verschlusselementes, insbesondere einer Tür oder Klappe zum Verschließen des gekühlten Innenraums bildet eine besonders wirksame Wärmedämmung, so dass im Betrieb eine vergleichsweise geringe Leistung, vorzugsweise Kälteleistung ausreicht, um die gewünschte Temperatur zu erhalten.

Besonders bevorzugt ist eine Ausführung, bei der zwischen der den Innenraum begrenzenden Innenwand und der Außenhaut eine Wärmedämmung angeordnet ist, die aus einem Vollvakuumsystem besteht. Darunter ist eine Wärmedämmung zu verstehen, die überwiegend aus einem evakuierten Bereich besteht, der mit einem Kernmaterial gefüllt ist. Die Begrenzung dieses Bereiches kann beispielsweise durch eine vakuumdichte Folie und vorzugsweise durch eine Hochbarrierefolie gebildet werden. Somit kann zwischen der Innenwand des Geräts und der Außenhaut des

Gerätes, als Wärmedämmung ein solcher Folienkörper vorliegen, der einen durch eine vakuumdichte Folie umgebenen Bereich aufweist, in dem Vakuum herrscht und in dem ein Kernmaterial angeordnet ist. Eine Ausschäumung und/oder Vakuumisolationspaneele als Wärmedämmung oder eine sonstige Wärmedämmung außer dem Vollvakuumsystem zwischen der Innenseite und der Außenseite des Behältnisses bzw. Gerätes sind vorzugsweise nicht vorgesehen.

Diese bevorzugte Art der Wärmedämmung in Form eines Vollvakuumsystems kann sich teilweise zwischen der den Innenraum begrenzenden Wand und der Außenhaut des Korpus und/oder zwischen der Innenseite und der Außenseite des Verschlusselementes, wie z.B. einer Tür, Klappe, Deckel oder dergleichen erstrecken.

Das Vollvakuumsystem kann so erhalten werden, dass eine Umhüllung aus einer gasdichten Folie mit einem Kernmaterial gefüllt und anschließend vakuumdicht versiegelt wird. In einer Ausführungsform erfolgt sowohl das Befüllen als auch das vakuumdichte Versiegeln der Umhüllung bei Normal- bzw. Umgebungsdruck. Die Evakuierung erfolgt dann durch Anschluss einer geeigneten in die Umhüllung eingearbeiteten Schnittstelle, beispielsweise eines Evakuierungsstutzens, der ein Ventil aufweisen kann, an eine Vakuumpumpe. Vorzugsweise herrscht während der Evakuierung außerhalb der Umhüllung Normal- bzw. Umgebungsdruck. Es ist in dieser Ausführungsform vorzugsweise zu keinem Zeitpunkt der Herstellung erforderlich, die Umhüllung in eine Vakuumkammer einzubringen. Insofern kann in einer Ausführungsform während der Herstellung der Vakuumdämmung auf eine Vakuumkammer verzichtet werden.

In einer bevorzugten Ausgestaltung der Erfindung nimmt die Dicke des Festkörpers zu dem thermoelektrischen Element hin zu. In Richtung von dem thermoelektrischen Element weg kann sich die Dicke des Festkörpers verringern, dafür dessen flächenmäßige Erstreckung zunehmen.

Weiterhin kann vorgesehen sein, dass wenigstens eine Befestigungsvorrichtung, vorzugsweise wenigstens ein Spannkörper vorhanden ist, der zumindest einen der Festkörper an dem thermoelektrischen Element fixiert, wobei vorgesehen ist, dass die Befestigungsvorrichtung eine geringere Wärmeleitfähigkeit aufweist als der Festkörper. Die Befestigungsvorrichtung kann beispielsweise aus Kunststoff bestehen.

Wie oben ausgeführt, besteht eine bevorzugte Ausgestaltung der Erfindung darin, dass der Festkörper aus Aluminium besteht oder Aluminium aufweist.

In einer weiteren Ausgestaltung der Erfindung ist vorgesehen, dass der Festkörper bzw. die Innenwand des Gerätes derart ausgebildet ist, dass sich an wenigstens einer Position an der Oberfläche des Festkörper bzw. der Innenwand eine geringere Temperatur ergibt als in anderen Bereichen der Oberfläche des Festkörpers oder der Innenwand und dass Mittel zur Abfuhr des dort entstehenden Kondensats vorgesehen sind.

In einer Ausführungsform ist vorgesehen, dass es sich insbesondere um ein Haushaltsgerät bzw. ein gewerbliches Kühlgerät handelt. Beispielsweise sind solche Geräte umfasst, die für eine stationäre Anordnung im Haushalt, in einem Hotelzimmer, in einer gewerblichen Küche oder in einer Bar konzipiert sind. Beispielsweise kann es sich auch um einen Weinkühlschrank handeln. Ferner sind auch Kühl- und/oder Gefriertruhen von der Erfindung umfasst. Die erfindungsgemäßen Geräte können eine Schnittstelle zur Anbindung an eine Stromversorgung, insbesondere an ein Haushaltsstromnetz (z.B. einen Stecker) und eine Steh- oder Einbauhilfe wie beispielsweise Stellfüße oder Schnittstelle zur Fixierung innerhalb einer Möbelnische aufweisen. Beispielsweise kann es sich bei dem Gerät um ein Einbaugerät oder auch um ein Standgerät handeln.

In einer Ausführungsform ist das Gerät derart ausgebildet, dass es mit einer Wechselspannung, wie beispielsweise mit einer Hausnetzspannung von z.B. 120 V und 60 Hz oder 230 V und 50 Hz betrieben werden kann. In einer alternativen Ausführungsform ist das Gerät derart ausgebildet, dass es mit Gleichstrom einer Spannung von beispielsweise 5 V, 12 V oder 24 V betrieben werden kann. In dieser Ausgestaltung kann vorgesehen sein, dass innerhalb oder außerhalb des Gerätes ein Steckernetzteil vorgesehen ist, über welches das Gerät betrieben wird. Ein Vorteil der Verwendung von thermoelektrischen Wärmepumpen ist in dieser Ausführungsform, dass die komplette EMV-Problematik lediglich am Netzteil auftritt.

Insbesondere kann vorgesehen sein, dass das Kühl- und/oder Gefriergerät eine schrankartige Gestalt hat und einen Nutzraum aufweist, der an seiner Vorderseite (im Falle einer Truhe an der Oberseite) für einen Benutzer zugänglich ist. Der Nutzraum kann in mehrere Kompartimente unterteilt sein, die alle bei derselben oder bei unterschiedlichen Temperaturen betrieben werden. Alternativ kann lediglich ein Kompartiment vorgesehen sein. Innerhalb des Nutzraumes bzw. eines Kompartiments können auch Lagerungshilfen wie beispielsweise Ablagefächer, Schubladen oder Flaschenhalter (im Falle einer Truhe auch Raumteiler) vorgesehen sein, um eine optimale Lagerung von Kühl- oder Gefriergütern und eine optimale Platzausnützung zu gewährleisten.

Der Nutzraum kann durch wenigstens eine um eine vertikale Achse schwenkbare Türe verschlossen sein. Im Falle einer Truhe ist eine um eine horizontale Achse schwenkbare Klappe oder ein Schiebedeckel als Verschlusselement denkbar. Die Türe oder ein sonstiges Verschlusselement kann im geschlossenen Zustand anhand einer umlaufenden Magnetdichtung mit dem Korpus im Wesentlichen luftdicht in Verbindung stehen. Vorzugsweise ist auch die Türe bzw. ein sonstiges Verschlusselement wärmeisoliert, wobei die Wärmeisolierung anhand einer Ausschäumung und ggf. anhand von Vakuumisolationspaneelen erreicht werden kann, oder auch vorzugsweise anhand eines Vakuumsystems und besonders bevorzugt anhand eines Vollvakuumsystems. An der Innenseite der Türe können ggf. Türabsteller vorgesehen sein, um auch dort Kühlgüter lagern zu können.

In einer Ausführungsform kann es sich um ein Kleingerät handeln. In derartigen Geräten weist der Nutzraum, der durch die Innenwand des Behälters definiert ist, beispielsweise ein Volumen von kleiner 0,5 m³, kleiner 0,4 m³ oder kleiner 0,3 m³ auf.

Die Außenabmessungen des Gerätes liegen vorzugsweise im Bereich bis 1 m hinsichtlich der Höhe, der Breite und der Tiefe.

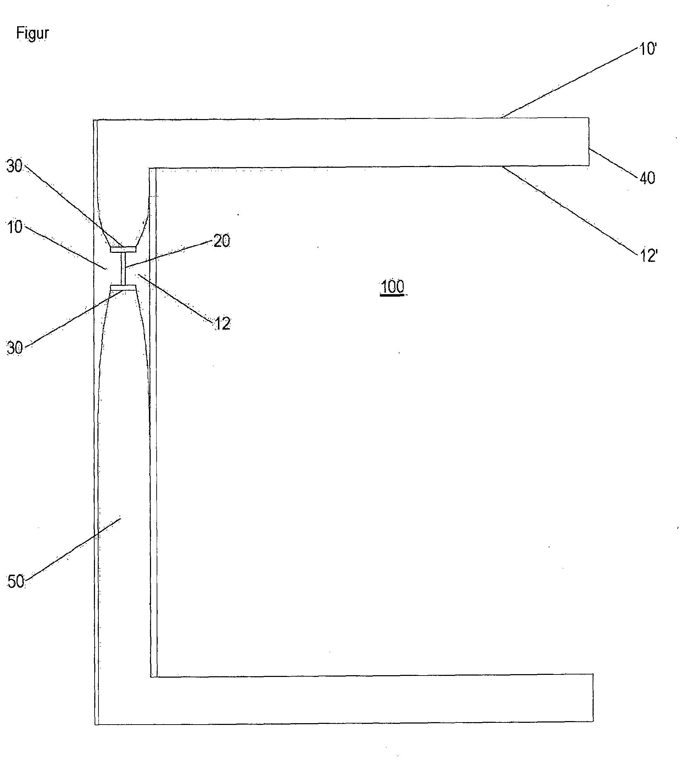

Weitere Einzelheiten und Vorteile der Erfindung werden anhand eines in der Zeichnung dargestellten Ausführungsbeispiels näher erläutert.

Die einzige Figur zeigt eine Querschnittsansicht durch ein erfindungsgemäßes Kühlgerät.

Die Figur zeigt mit dem Bezugszeichen 10', 12' die aus Aluminium bestehende Gehäusewand, die die mit der Umgebung in Kontakt stehende Außenfläche und die Innenfläche des gekühlten Innenraums bildet.

Mit dem Bezugszeichen 20 ist ein Peltier-Element gekennzeichnet, das mit seinem kalten Bereich mit dem Aluminiumfestkörper 12 und mit einem warmen Bereich mit dem Aluminiumfestkörper 10 wärmeleitend in Verbindung steht.

Wie dies aus der Figur hervorgeht, nimmt die Dicke, d.h. die Erstreckung der Körper 10, 12 senkrecht zur Außen- und Innenseite des Gerätes zu dem Peltier-Element 20 hin zu.

Die flächenmäßige Erstreckung der Körper 10, 12 in einer Richtung parallel zur Außen- und Innenseite nimmt hingegen von außen und von innen zu dem Peltier-Element hin ab.

Das Bezugszeichen 30 kennzeichnet eine Spannvorrichtung, die die Körper 10, 12 an dem Peltier-Element 20 nach Anspruch 5 fixiert.

Das Bezugszeichen 40 kennzeichnet die Türdichtung sowie das Labyrinth in vereinfachter Darstellung. Die Gerätetür ist nicht dargestellt.

Mit dem Bezugszeichen 50 ist die Vakuumdämmung gekennzeichnet, die sich zwischen der Innenwand 12' und der Außenwand 10' erstreckt. Aufgrund des durch die Vakuumdämmung geringen Wärmeeintrags ist die vergleichsweise geringe Wärmeleistung durch das Peltier-Element 20 zur Kühlung des Innenraums 100 ausreichend.

Wie dies aus der Figur weiter hervorgeht, bilden die Festkörper 10, 12, die wärmeleitend mit dem Peltier-Element 20 verbunden sind, nicht nur die "Wärmetransportmittel", sondern auch gleichzeitig die Innenwand 12' sowie die Außenwand 10' des Gerätes.

Der Wärmeübergang zu der Innenwand 12' und von der Außenwand 10' erfolgt statisch, d.h. ohne die Verwendung von Ventilatoren, wodurch sich eine entsprechende Energieeinsparung ergibt.

Bei dem in der Figur gezeichneten Ausführungsbeispiel erfolgt der Wärmetransport von innen nach außen ausschließlich durch die Festkörper 10, 12 und das thermoelektrische Element (20).

## Patentansprüche

1. Kühl- und/oder Gefriergerät mit
einem temperierten, gekühlten Innenraum (100),
einem thermoelektrischen Element (20) zur Kälteerzeugung in dem gekühlten Innenraum (100),
einem ersten Festkörper (12), der derart angeordnet ist, dass eine Ableitung von Wärme aus dem gekühlten Innenraum (100) zu dem thermoelektrischen Element (20) durch Wärmeleitung mittels des ersten Festkörpers (12) erfolgt, und
einem zweiten Festkörper (10), der derart angeordnet ist, dass eine Ableitung von Wärme weg von dem thermoelektrischen Element (20) durch Wärmeleitung mittels des zweiten Festkörpers (10) erfolgt, wobei
der erste Festkörper (12) eine Innenwand (12') des Gerätes bildet, und
der zweite Festkörper (10) eine Außenwand (10') des Gerätes bildet,
**dadurch gekennzeichnet, dass**
der Wärmetransport von innen nach außen ausschließlich durch den ersten Festkörper (10), das thermoelektrische Element (20) und den zweiten Festkörper (12) erfolgt.

2. Kühl- und/oder Gefriergerät nach Anspruch 1, **dadurch gekennzeichnet, dass** es als Wärmedämmung des vorzugsweise gekühlten Innenraums (100) eine Vakuumdämmung (50) aufweist, die den vorzugsweise gekühlten Innenraum (100) teilweise umgibt.

3. Kühl- und/oder Gefriergerät nach Anspruch 2, **dadurch gekennzeichnet, dass** zwischen der den Innenraum (100) begrenzenden Innenwand (12') und der Außenwand (10') des Kühl- und/oder Gefriergeräts eine Wärmedämmung angeordnet ist, die bereichsweise aus einem Vollvakuumsystem besteht.

4. Kühl- und/oder Gefriergerät nach einem der vorhergehenden Ansprüche, **dadurch gekennzeichnet, dass** die Dicke des ersten und/oder des zweiten Festkörpers (10, 12) zu dem thermoelektrischen Element (20) hin zunimmt.

5. Kühl- und/oder Gefriergerät nach einem der vorhergehenden Ansprüche, **dadurch gekennzeichnet, dass** wenigstens eine Befestigungsvorrichtung, vorzugsweise wenigstens ein Spannkörper vorgesehen ist, der den ersten und/oder den zweiten Festkörper (10, 12) an dem thermoelektrischen Element (20) fixiert, wobei vorgesehen ist, dass die Befestigungsvorrichtung eine geringere Wärmeleitfähigkeit aufweist als der erste und der zweite Festkörper (10, 12) und/oder dass die Befestigungsvorrichtung aus Kunststoff ausgeführt ist.

6. Kühl- und/oder Gefriergerät nach einem der vorhergehenden Ansprüchen, **dadurch gekennzeichnet, dass** der erste und/oder der zweite Festkörper (10, 12) aus Aluminium besteht oder Aluminium aufweist.

7. Kühl- und/oder Gefriergerät nach einem der vorhergehenden Ansprüche, **dadurch gekennzeichnet, dass** der erste Festkörper (12) bzw. die Innenwand (12') des Gerätes derart ausgebildet ist, dass sich an wenigstens einer Position an der Oberfläche des ersten Festkörpers (12) bzw. der Innenwand (12') eine geringere Temperatur ergibt als in anderen Bereichen der Oberfläche des Festkörpers oder der Innenwand (12') und dass Mittel zur Abfuhr des dort entstehenden Kondensats vorgesehen sind.

## Claims

1. Refrigerator and/or freezer device, having
a temperature-controlled, cooled inner space (100),
a thermoelectric element (20) for cold production in the cooled inner space (100),
a first solid body (12) which is arranged such that a dissipation of thermal energy from the cooled inner space (100) to the thermoelectric element (20) takes place by thermal conduction by means of the first solid body(10),
a second solid body (10), which is arranged such that a dissipation of thermal energy away from the thermoelectric element (20) takes place by thermal conduction by means of the second solid body (10), wherein
the first solid body (12) forms an inner wall (12') of the device, and
the second solid body (10') forms an outer wall (10') of the device,
**characterized in that**
the transport of thermal energy from inside to outside takes place exclusively by the first solid body (10), the thermoelectric element (20) and the second solid body (12).

2. Refrigerator and/or freezer device according to claim 1, **characterized in that** it comprises a vacuum insulation (50) which partly surrounds the preferably cooled inner space (100) as a heat insulation of the preferably cooled inner space (100).

3. Refrigerator and/or freezer device according to claim 2, **characterized in that** a heat insulation which regionally consists of a full vacuum system is arranged between the inner wall (12') bounding the inner space (100) and the outer wall (10') of the refrigerator and/or freezer device.

4. Refrigerator and/or freezer device in accordance with one of the preceding claims, **characterized in that** the thickness of the first and/or second solid body (10, 12) increases toward the thermoelectric element (20).

5. Refrigerator and/or freezer device in accordance with one of the preceding claims, **characterized in that** at least one fastening apparatus, preferably at least one clamping body, is provided which fixes the first and/or the second solid body (10, 12) to the thermoelectric element (20), with provision is made that the fastening apparatus has a smaller thermal conductivity than the first and the second solid body (10, 12) and/or **in that** the fastening apparatus is formed from plastic.

6. Refrigerator and/or freezer device in accordance with one of the preceding claims, **characterized in that** the first and/or the second solid body (10, 12) consists of aluminum or comprises aluminum.

7. Refrigerator and/or freezer device in accordance with one of the preceding claims, **characterized in that** the first solid body (12) or the inner wall (12') of the device is configured such that a smaller temperature results on at least one position at the surface of the first solid body (12) or the inner wall (12') than in other regions of the surface of the solid body or of the inner wall (12') and that means for dissipating the condensation arising there are provided.

## Revendications

1. Appareil de réfrigération et/ou de congélation comprenant
un espace intérieur (100) réfrigéré thermorégulé,
un élément thermoélectrique (20) destiné à produire du froid dans l'espace intérieur (100) réfrigéré,
un premier corps solide (12), qui est agencé de telle manière qu'une dissipation de chaleur provenant de l'espace intérieur (100) réfrigéré vers l'élément thermoélectrique (20) est effectuée par conduction de chaleur au moyen du premier corps solide (12), et
un second corps solide (10), qui est agencé de telle manière qu'une dissipation de chaleur depuis l'élément thermoélectrique (20) est effectuée par conduction de chaleur au moyen du second corps solide (10),
le premier corps solide (12) formant une paroi intérieure (12') de l'appareil, et le second corps solide (10) formant une paroi extérieure (10') de l'appareil,
**caractérisé en ce que**
le transport de chaleur de l'intérieur vers l'extérieur est effectué exclusivement à travers le premier corps solide (10), l'élément thermoélectrique (20) et le second corps solide (12).

2. Appareil de réfrigération et/ou de congélation selon la revendication 1, **caractérisé en ce qu'**il comporte, comme isolation thermique de l'espace intérieur (100) de préférence réfrigéré, une isolation sous vide (50), qui entoure partiellement l'espace intérieur (100) de préférence réfrigéré.

3. Appareil de réfrigération et/ou de congélation selon la revendication 2, **caractérisé en ce qu'**une isolation thermique, qui consiste, dans certaines zones, en un système de vide complet, est agencée entre la paroi intérieure (12') délimitant l'espace intérieur (100) et la paroi extérieure (10') de l'appareil de réfrigération et/ou de congélation.

4. Appareil de réfrigération et/ou de congélation selon l'une des revendications précédentes, **caractérisé en ce que** l'épaisseur du premier et/ou du second corps solide (10, 12) augmente en direction de l'élément thermoélectrique (20).

5. Appareil de réfrigération et/ou de congélation selon l'une des revendications précédentes, **caractérisé en ce qu'**au moins un dispositif de fixation, de préférence au moins un corps de serrage, est prévu, qui fixe le premier et/ou le second corps solide (10, 12) à l'élément thermoélectrique (20), le dispositif de fixation étant prévu de façon à présenter une conductibilité thermique inférieure au premier et au second corps solide (10, 12) et/ou que le dispositif de fixation est réalisé en matière plastique.

6. Appareil de réfrigération et/ou de congélation selon l'une des revendications précédentes, **caractérisé en ce que** le premier et/ou le second corps solide (10, 12) consiste en aluminium ou comporte de l'aluminium.

7. Appareil de réfrigération et/ou de congélation selon l'une des revendications précédentes, **caractérisé en ce que** le premier corps solide (12) ou la paroi intérieure (12') de l'appareil est réalisé(e) de telle manière qu'une température plus faible est obtenue en au moins une position sur la surface du premier corps solide (12) ou de la paroi intérieure (12') que dans d'autres zones de la surface du corps solide ou de la paroi intérieure (12') et **en ce que** des moyens sont prévus pour l'évacuation du condensat qui s'y forme.
